# EUROPEAN PATENT SPECIFICATION

(11) **EP 4 192 210 B1**
(45) Date of publication and mention of the grant of the patent: **03.06.2026**
(21) Application number: 21855414.5
(22) Date of filing: 03.08.2021
(51) Int. Cl.: H05K 7/20, G03B 17/55, G03B 17/02, H04N 23/52, G08B 13/196, G03B 17/08

(54) **ELECTRONIC DEVICE AND EXTENSION ASSEMBLY**
ELEKTRONISCHE VORRICHTUNG UND ERWEITERUNGSANORDNUNG
DISPOSITIF ÉLECTRONIQUE ET ENSEMBLE D'EXTENSION

(30) Priority: 13.08.2020 CN 202010814994
(43) Date of publication of application: 07.06.2023
(73) Proprietor: Huawei Technologies Co., Ltd., Shenzhen, Guangdong 518129 (CN)
(72) Inventor: WAN, Junping, Shenzhen, Guangdong 518129 (CN); DU, Yang, Shenzhen, Guangdong 518129 (CN); XIONG, Jian, Shenzhen, Guangdong 518129 (CN); LV, Danhua, Shenzhen, Guangdong 518129 (CN)
(74) Representative: Gill Jennings & Every LLP
(86) International application number: PCT/CN2021/110380
(87) International publication number: WO 2022/033361

(56) References cited:
- CN-A- 105 867 053
- CN-A- 112 074 112
- CN-A- 112 702 480
- CN-U- 202 189 312
- CN-U- 207 783 398
- CN-U- 207 783 398
- CN-U- 208 285 412
- CN-Y- 201 039 635
- US-A1- 2013 278 820
- US-A1- 2013 278 820
- US-A1- 2018 376 037
- US-A1- 2019 154 949

## Description

### TECHNICAL FIELD

This application relates to the field of electronic device technologies, and in particular, to an electronic device and an extension assembly.

### BACKGROUND

Cameras are widely used in daily lives of people. For example, a camera may be used in environments such as a road, a campus, or an indoor environment to implement functions such as image collection. With development of science and technology and an increasing requirement of people, users hope that a camera can have richer functions. For example, some users hope that a camera can have a wireless communication function. Some users hope that a camera can have functions such as face recognition and vehicle license plate recognition. To meet different requirements of different customers, a required functional circuit (such as a communication circuit and a processor) may be added to the camera. However, in actual application, to meet an air tightness requirement of a lens assembly in the camera, the required functional circuit needs to be mounted in the camera before factory delivery, and the required functional circuit cannot be mounted in the camera after factory delivery or on-site application. Therefore, functional insufficiency, functional redundancy, or the like of the camera may be caused.
US 2019/154949 A1 discloses a heat dissipation module suitable for a system camera formed by a plurality of modules. US 2018/376037 A1 discloses an electronic apparatus capable of efficiently cooling first and second circuit boards, using one cooling fan. US 2013/278820 A1 discloses a monitoring device with independent heat dissipation for an image capture component. CN 207 783 398 U discloses a radiator structure and smart electronics to set the radiator structure in standby.

### SUMMARY

This application provides an electronic device, including a main device assembly and an extension assembly. The main device assembly includes a main body circuit. The extension assembly includes one or more functional circuits and a housing; at least one of the one or more functional circuits is electrically connected to the main body circuit; and the housing includes an inner housing and an outer housing. A ventilation channel is formed on an inner circumference of the inner housing. The outer housing is disposed on an outer circumference of the inner housing, and the inner housing and the outer housing enclose to form an accommodating space. The functional circuit is disposed in the accommodating space and is in heat contact with the inner housing, so that heat dissipation is performed on the functional circuit through an air flow in the ventilation channel. In the electronic device provided in this application, the extension assembly is in a hollowed-out chimney-like structure as a whole, and when flowing through the ventilation channel of the inner housing, an external air flow takes away heat of the inner housing. In addition, because the functional circuit (which may be specifically a heating element such as a processor in the functional circuit) is in heat contact with the inner housing (the heat contact means contact that can transfer heat, for example, direct contact or contact via a thermal adhesive or a thermal pad), heat generated by the functional circuit can be effectively transmitted to the inner housing, thereby facilitating heat dissipation of the functional circuit. In actual application, a required functional circuit may be mounted in the extension assembly before factory delivery, or the required functional circuit may be mounted in the extension assembly on an engineering site. Therefore, there is great flexibility, and an undesirable problem of functional insufficiency or functional redundancy is not caused. In addition, disassembly/assembly of the main device assembly does not need to be performed when a functional assembly is mounted, so that air tightness of the main device assembly is not affected. When the extension module is mounted on the main device assembly (such as a camera), the extension assembly does not affect heat dissipation performance of the main device assembly. In addition, because the extension assembly is a structure independent of the main device assembly, when there are different function requirements of the main device assembly, only corresponding functional circuits need to be mounted in the extension assembly. That is, the extension assembly and the main device assembly use a separate-cavity architecture form, so that the extension assembly can be mounted at a position away from the main device assembly, thereby reducing impact of the extension assembly on heat dissipation of the main device assembly. In specific implementation, types and quantities of functional circuits that can be included in the extension assembly may be various. For example, the functional circuit may be a communication circuit such as a radar, a Wi-Fi module, a 4G communication module, a 5G communication module, or a Bluetooth module; or may be a device such as a graphics processing unit, an AI processing chip, or a memory. In actual application, the required functional circuit may be mounted in the extension assembly before factory delivery, or the required functional circuit may be mounted in the extension assembly on an engineering site. Therefore, there is great flexibility, and an undesirable problem of functional insufficiency or functional redundancy is not caused. In addition, disassembly/assembly of the main device assembly (such as a camera) does not need to be performed when the functional assembly is mounted, so that air tightness of the main device assembly is not affected.

In addition, in specific implementation, the housing may be an integrated structural member, or may be formed by splicing a plurality of components.

The housing includes an inner housing and an outer housing. The inner housing may be constructed in a tubular structure, and the outer housing may also be constructed in a tubular structure, which may be a circular tube structure, or any other regular or irregular tubular structure. The outer housing is sleeved onto an outer circumference of the inner housing, and a gap used to form the accommodating space is maintained between the outer housing and the inner housing. In addition, to implement an airtight connection between the inner housing and the outer housing, the housing further includes an upper cover and a bottom housing. Both the upper cover and the bottom housing are constructed in a circular plate-like structure. Specifically, an inner edge of the bottom housing is airtightly connected to a first end of the inner housing, and an outer edge of the bottom housing is airtightly connected to a first end of the outer housing. An inner edge of the upper cover is airtightly connected to a second end of the inner housing, and an outer edge of the upper cover is airtightly connected to a second end of the outer housing. In specific configuration, a cross section of the heat dissipation channel may be a circular, oval, square, or another polygon structure, or it may be understood that a cross section of an inner contour of the inner housing may be a circular, oval, square, or another polygon structure. In addition, shapes of the inner contour and an outer contour of the inner housing may be the same or different. For example, cross sections of the inner contour and the outer contour of the inner housing may be circular, or the cross section of the inner contour of the inner housing is circular, and the cross section of the outer contour of the inner housing is square. Correspondingly, a cross section of an inner contour of the outer housing may be a circular, oval, square, or another polygon structure. In addition, shapes of the inner contour and an outer contour of the outer housing may be the same or different. For example, cross sections of the inner contour and the outer contour of the outer housing may be circular, or the cross section of the inner contour of the outer housing is circular, and the cross section of the outer contour of the outer housing is square.

In specific implementation, to ensure airtightness of the accommodating space, a sealing ring may be disposed or a sealant may be applied on a part of the upper cover that is connected to the inner housing and the outer housing. Correspondingly, a sealing ring may also be disposed or a sealant may be applied on a part of the bottom housing that is connected to the inner housing and the outer housing. In addition, in specific implementation, manners of connecting the upper cover to the inner housing and the outer housing may also be various. Manners of connecting the bottom housing to the inner housing and the outer housing may also be various. For example, the inner housing and the upper cover may be connected in a manner of a threaded connection. Specifically, an inner thread may be disposed on an inner edge of the upper cover, and an outer thread may be disposed on a second end of the inner housing. After the outer thread of the inner housing and the inner thread of the upper cover are screwed, a fixed connection between the inner housing and the upper cover can be implemented. In addition, to ensure airtightness of the screw part, a sealing ring may be disposed or a sealant may be applied on the screw part.

In addition, in specific implementation, the inner housing, the outer housing, the upper cover, and the bottom housing may be mutually independent structural members, or may be partially integrated structural members. For example, the inner housing and the bottom housing may be of an integrated structure. The outer housing and the upper cover may be of an integrated structure.

In addition, the functional circuit in the extension assembly may need to be electrically connected to the main body circuit in the main device assembly by using a cable, to meet a power supply requirement of the extension assembly or a signal transmission requirement between the extension assembly and the main device assembly. Therefore, a cable hole communicating with the accommodating space may be disposed on the housing. In specific implementation, the cable hole may be disposed on the bottom housing, or may be disposed on the inner housing or the outer housing.

To improve heat dissipation performance of the extension assembly, the inner housing may be made of a metal material with good thermal conductivity, for example, aluminum or an aluminum alloy. In addition, a heating element (such as a processor) of the functional circuit may be in heat contact with an outer wall of the inner housing, so that heat generated by the heating element can be efficiently transmitted to the inner housing.

Alternatively, in some other implementations, the outer housing may also be made of a metal material with good thermal conductivity, for example, aluminum or an aluminum alloy. In addition, the heating element of the functional circuit may also be in heat contact with an inner wall of the outer housing, so that heat generated by the heating element can be efficiently transmitted to the outer housing.

In addition, in actual application, when the functional circuit includes wireless communication circuits such as a radar, a Wi-Fi module, and a 4G communication module, to prevent the housing from shielding the functional circuit, the outer housing may be made of a non-electromagnetic shielding material such as polycarbonate or ABS plastic (including a copolymer of acrylonitrile, butadiene, and styrene), to ensure normal operation of the functional circuit.

In addition, the extension assembly may be applied to a harsh environment such as an outdoor environment. To improve a use effect of the extension assembly, the extension assembly may further include a shielding cover assembly. The shielding cover assembly may cover the outside of the housing to prevent the housing from being exposed to sunlight, resulting in an undesirable case such as a high temperature.

In specific implementation, the shielding cover assembly may include a shielding cover. The shielding cover may cover a top and an outer circumference of the housing. A ventilation hole is disposed on the top of the shielding cover. In specific implementation, the shielding cover may cover the top of the housing. In addition, an air flow flowing through the ventilation channel may also be discharged by using the ventilation hole of the shielding cover. Therefore, the shielding cover does not hinder the ventilation channel of the inner housing, and therefore does not affect heat dissipation performance of the extension assembly.

In addition, to prevent an impurity such as a leaf from falling into the ventilation channel to cause blockage, the shielding cover assembly may further include a shutter. The shutter may be disposed on the top of the shielding cover, to shield the ventilation hole. In addition, to prevent the shutter from hindering the ventilation channel, a specific ventilation gap is maintained between the shutter and the shielding cover, and the air flow flowing through the ventilation channel can be discharged upward through the ventilation gap.

In actual application, to improve heat dissipation of the extension assembly by using a principle that a hot air flow rises, after the extension assembly is fastened at a mounting position, the ventilation channel may maintain a vertical or inclined posture, so that the hot air flow in the ventilation channel can be smoothly discharged upward.

In addition, to improve heat dissipation performance of the extension assembly and flexibility of a mounting posture, in some other implementations, a heat dissipation fan may further be disposed in the extension assembly. For example, the heat dissipation fan may be fixedly mounted in the ventilation channel or at another position, to increase a flow velocity of the air flow flowing through the ventilation channel, thereby improving a heat dissipation capability of the extension assembly.

The extension assembly is detachably connected to the main device assembly, the housing of the extension assembly is connected to the main device outer housing of the main device assembly by using a structure such as a screw or a hook. In addition, to improve heat dissipation of the main device assembly, a first mounting gap is further disposed between the extension assembly and the main device assembly, and the first mounting gap communicates with the ventilation channel. When there is an air flow in the ventilation channel, an air flow in the first mounting gap may be caused to flow, so that heat of the main device assembly can be quickly taken away. In specific implementation, the main device outer housing of the main device assembly may include a base, the base is located on a side of the first mounting gap, and the main body circuit in the main device assembly may be mounted in the base and is in heat contact with the base. Specifically, the heating element in the main body circuit may be in heat conducting contact with the base by using a thermal adhesive, a thermal pad, or the like. Heat generated by the heating element can be rapidly transmitted to the base, and heat dissipation is performed on the base rapidly by using an air flow flowing through the first mounting gap, thereby effectively improving a heat dissipation effect of the main body circuit.

When the extension assembly includes the shielding cover, the shielding cover may further cover at least a part of the peripheral of the main device assembly, so that the main device assembly can provide a specific shielding effect. In addition, to ensure heat dissipation performance of the main device assembly and the extension assembly, a specific gap may be maintained between the shielding cover and the main device assembly, so that an external air flow can enter the mounting gap (the first mounting gap or the second mounting gap) through the gap. Further, when the air flow flows through the mounting gap, the air flow enters the ventilation channel, and then is discharged from the top of the ventilation channel.

In specific application, the main device assembly may be a camera, an outdoor base station (for example, a base station configured to receive and send a wireless signal), or the like. A type of the main device assembly is not limited in this application.

### BRIEF DESCRIPTION OF DRAWINGS

FIG. 1 is a schematic diagram of a cross-section structure of an extension assembly according to an embodiment of this application;
FIG. 2 is an exploded view of another extension assembly according to an embodiment of this application;
FIG. 3 is a schematic diagram of a cross-section structure of another extension assembly according to an embodiment of this application;
FIG. 4 is a schematic diagram of a cross-section structure of another extension assembly according to an embodiment of this application;
FIG. 5 is a schematic diagram of a cross-section structure of another extension assembly according to an embodiment of this application;
FIG. 6 is a schematic diagram of a structure of a camera according to an embodiment of this application;
FIG. 7 is a schematic diagram of a cross-section structure of a camera according to an embodiment of this application;
FIG. 8 is a schematic diagram of a structure of another camera according to an embodiment of this application;
FIG. 9 is an exploded view of a camera according to an embodiment of this application; and
FIG. 10 is a schematic diagram of a structure of another camera according to an embodiment of this application.

### DESCRIPTION OF EMBODIMENTS

To make objectives, technical solutions, and advantages of this application clearer, the following further describes this application in detail with reference to the accompanying drawings.

To facilitate understanding of an extension assembly provided in embodiments of this application, the following first describes an application scenario of the extension assembly.

The extension assembly provided in this application may be applied to a main device assembly such as a camera or an outdoor base station, to extend and improve functionality of the corresponding main device assembly. A camera is used as an example. The camera usually includes a lens assembly, to implement a collection function of image information. Currently, to enable the camera to have a specific information processing capability (for example, face recognition and vehicle license plate recognition), some manufacturers usually add an extra processor inside the camera, but the processor generates a large amount of heat during normal operation. Because the lens assembly is a heat sensitive component with a low temperature specification, when the processor generates a large amount of heat, normal operation of the lens assembly is affected, and power and performance of the processor are greatly limited, posing a great challenge to a heat dissipation capability of the camera. In addition, to ensure air tightness of the lens assembly, a mounting operation of the processor can only be performed before factory delivery of the camera. Therefore, the mounting operation of the processor cannot be adjusted properly on an engineering site. In addition, to enable the camera to have a wireless communication function, some manufacturers usually add a wireless communication circuit to the camera. However, in actual application, to meet a heat dissipation requirement of the camera, the camera usually uses a metal outer housing, for example, an aluminum alloy. Therefore, to prevent a signal of the wireless communication circuit from being shielded by the metal outer housing, the wireless communication circuit can only be mounted on an outer housing of the camera, but cannot be mounted inside the camera. When the wireless communication circuit is mounted on the outer housing, a part of an area of the outer housing is occupied, thereby reducing heat dissipation of the camera. In addition, in actual application, the wireless communication circuit needs to connect to a camera body by using a cable, and a position at which the cable is connected to the camera body needs to be sealed, to ensure air tightness of the lens assembly. In addition, after the sealing operation is completed, the lens assembly needs to be tested for air tightness. Therefore, a mounting operation of the wireless communication circuit can only be performed before factory delivery, but cannot be performed on the engineering site (or after factory delivery of the camera). This causes a large limitation.

In actual application, because the camera has a plurality of different application scenarios, and function requirements of different users on the camera are also different, a type and a quantity of functional circuits added to the camera are also greatly different. However, due to an air tightness requirement of the lens assembly (or the camera), a functional circuit mounted in the camera can only be configured before factory delivery. In actual application, an undesirable case of functional insufficiency or functional redundancy may be caused. In addition, because there is no heat dissipation structure in some mounted functional circuits, heat dissipation needs to be performed relying on a housing of the camera. This affects heat dissipation performance of the camera. It may be understood that the foregoing uses only the camera as an example for brief description. However, in actual application, when the functional circuit is mounted in the main device assembly, for example, an outdoor base station (for example, a base station used to receive and send a wireless signal), a technical problem same as or similar to that of the foregoing camera also exists.

Therefore, embodiments of this application provide an extension assembly that can be flexibly mounted and that does not affect heat dissipation performance of an electronic device and an electronic device equipped with the extension assembly.

To make objectives, technical solutions, and advantages of this application clearer, the following further describes this application in detail with reference to the accompanying drawings.

Terms used in the following embodiments are merely intended to describe particular embodiments, but are not intended to limit this application. The terms "one", "a" and "this" of singular forms used in this specification and the appended claims of this application are also intended to include expressions such as "one or more", unless otherwise specified in the context clearly. It should be further understood that, in the following embodiments of this application, "at least one" and "one or more" mean one, two, or more. The term "and/or" describes an association relationship between associated objects, and represents that three relationships may exist. For example, A and/or B may represent the following cases: Only A exists, both A and B exist, and only B exists, where A and B may be singular or plural. The character "/" usually indicates an "or" relationship between associated objects.

Referring to "one embodiment", "some embodiments", or the like described in this specification means that specific features, structures, or characteristics described with reference to the embodiments are included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "contain", "have", and their variants all mean "include but are not limited to", unless otherwise specifically emphasized in another manner.

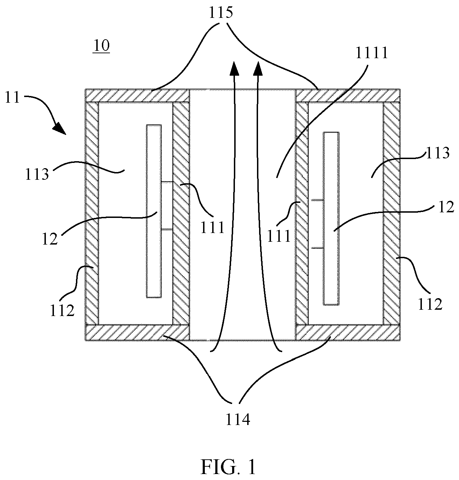

As shown in FIG. 1, an embodiment of this application provides an extension assembly 10, configured to extend or improve functionality of a main device assembly. The extension assembly 10 includes a housing 11 and a functional circuit 12 mounted in the housing 11. One or more functional circuits 12 may be disposed, and at least one functional circuit 12 is configured to electrically connect to a main body circuit in the main device assembly. The housing 11 includes an inner housing 111 and an outer housing 112, and an inner circumference of the inner housing 111 forms a ventilation channel 1111. The outer housing 112 is disposed on an outer circumference of the inner housing 111, and the inner housing 111 and the outer housing 112 enclose to form an accommodating space 113. The functional circuit 12 is disposed in the accommodating space 113 and is in heat contact with the inner housing 111, so that heat dissipation is performed on the functional circuit 12 through an air flow in the ventilation channel 1111. In addition, because the outer circumference of the outer housing 112 is not shielded and has a large heat dissipation area, the extension assembly 10 has a strong heat dissipation capability. When the extension assembly 10 is mounted on the main device assembly (such as a camera), the extension assembly 10 does not affect heat dissipation performance of the main device assembly. In addition, because the extension assembly 10 is a structure independent of the main device assembly, when there are different function requirements of the main device assembly, only corresponding functional circuits 12 need to be mounted in the extension assembly 10. In specific implementation, types and quantities of functional circuits 12 that can be included in the extension assembly 10 may be various. For example, the functional circuit 12 may be a communication circuit such as a radar, a Wi-Fi module, a 4G communication module, a 5G communication module, or a Bluetooth module; or may be a device such as a graphics processing unit, an AI processing chip, or a memory. In actual application, a required functional circuit 12 may be mounted in the extension assembly 10 before factory delivery, or the required functional circuit 12 may be mounted in the extension assembly 10 on an engineering site. Therefore, there is great flexibility, and an undesirable problem of functional insufficiency or functional redundancy is not caused. In addition, disassembly/assembly of the main device assembly (such as a camera) does not need to be performed when the functional circuit 12 is mounted, so that air tightness of the main device assembly is not affected.

The inner circumference of the inner housing 111 refers to a structural characteristic opposite to the outer circumference of the inner housing 111, or the inner circumference refers to a structural characteristic of a formed inner contour. For example, when the inner housing 111 is a cylindrical structure, the inner circumference of the inner housing 111 refers to an inner wall of the cylindrical structure, and the outer circumference of the inner housing 111 refers to an outer wall of the cylindrical structure.

In specific implementation, structures of the ventilation channel 1111 may be various. For example, a cross section of the ventilation channel 1111 may be a circular, square, rectangular, or another polygon structure. In addition, the ventilation channel 1111 may also be of a structure, such as a straight line type, a curved line type, or a folded line type in a length direction. This is not specifically limited in this application.

In specific implementation, to improve heat dissipation performance of the extension assembly 10, the inner housing 111 may be made of a metal material with good thermal conductivity, for example, aluminum or an aluminum alloy. In addition, the functional circuit 12 located in the accommodating space 113 may be in heat contact with an outer wall of the inner housing 111, so that heat generated by the functional circuit 12 can be efficiently transmitted to the inner housing 111. When there are a plurality of functional circuits 12 in the accommodating space 113, the plurality of functional circuits 12 may be disposed along a circumferential direction of the inner housing 111, and a heating element in each functional circuit 12 may be in heat contact with the outer wall of the inner housing 111, so that heat dissipation can be performed on the plurality of functional circuits 12 through the inner housing 111. Specifically, the heating element in the functional circuit 12 may be in heat contact with the inner housing 111 in a manner of using a thermal pad, a thermal adhesive, or the like. In addition, a structure such as a heat dissipation fin, a heat sink, or a heat conducting pipe may also be disposed on an inner wall of the inner housing 111, to improve heat dissipation of the inner housing 111. Alternatively, in some other implementations, when the functional circuit 12 does not include a wireless communication circuit (that is, the wireless communication circuit needs to transmit a wireless signal to the outside to operate normally), the outer housing 112 may also be made of a metal material with good thermal conductivity, for example, aluminum or an aluminum alloy. In addition, the functional circuit 12 located in the accommodating space 113 may be in heat contact with an inner wall of the outer housing 112, so that heat generated by the functional circuit 12 can be efficiently transmitted to the outer housing 112.

In some other implementations, when the functional circuit 12 includes a radar, a Wi-Fi module, and a 4G communication module, to prevent the housing 11 from shielding the functional circuit 12, the outer housing 112 may be made of a non-electromagnetic shielding material such as polycarbonate or ABS plastic (including a copolymer of acrylonitrile, butadiene, and styrene), to ensure normal operation of the functional circuit 12.

In addition, in some implementations, some functional circuits 12 may require high airtightness, to prevent impurities such as water vapor and dust from affecting normal operation of the functional circuits 12. Therefore, in specific implementation, the accommodating space 113 may also be an airtight space, that is, the inner housing 111 may be airtightly connected to the outer housing 112.

In specific implementation, specific structural shapes of the inner housing 111 and the outer housing 112 may be various, and there may be a plurality of manners of implementing an airtight connection between the corresponding inner housing 111 and outer housing 112.

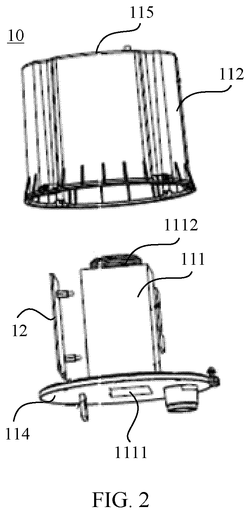

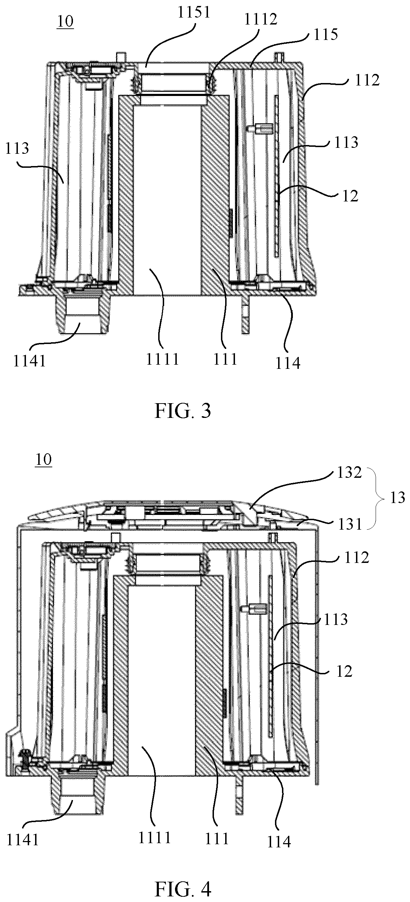

For example, as shown in FIG. 2 and FIG. 3, in an embodiment provided in this application, both the outer housing 112 and the inner housing 111 are tubular structures, and the outer housing 112 is sleeved onto the outer circumference of the inner housing 111. To implement an airtight connection between the outer housing 112 and the inner housing 111, the housing 11 further includes a bottom housing 114 and an upper cover 115, and a first end (a lower end in the figure) of the inner housing 111 and a first end (a lower end in the figure) of the outer housing 112 are airtightly connected by using the bottom housing 114. A second end (an upper end in the figure) of the inner housing 111 and a second end (an upper end in the figure) of the outer housing 112 are airtightly connected by using the upper cover 115. Specifically, in this embodiment provided in this application, both the bottom housing 114 and the upper cover 115 are of an annular plate-like structure. An inner edge of the bottom housing 114 is airtightly connected to a bottom edge of the inner housing 111, and an outer edge of the bottom housing 114 is airtightly connected to a bottom edge of the outer housing 112. In specific implementation, the bottom housing 114 may be airtightly connected to the inner housing 111 in a manner of welding, bonding, disposing a sealing ring, or the like. Correspondingly, the housing 114 may also be airtightly connected to the outer housing 112 in a manner of welding, bonding, disposing a sealing ring, or the like. In addition, an inner edge of the upper cover 115 is airtightly connected to a top edge of the inner housing 111, and an outer edge of the upper cover 115 is airtightly connected to a top edge of the outer housing 112. In specific implementation, the upper cover 115 may be airtightly connected to the inner housing 111 in a manner of welding, bonding, disposing a sealing ring, or the like. Correspondingly, the upper cover 115 may also be airtightly connected to the outer housing 112 in a manner of welding, bonding, disposing a sealing ring, or the like.

In specific configuration, a cross section of the heat dissipation channel 1111 may be a circular, oval, square, or another polygon structure, or it may be understood that a cross section of an inner contour of the inner housing 111 may be a circular, oval, square, or another polygon structure. In addition, shapes of the inner contour and an outer contour of the inner housing 111 may be the same or different. For example, cross sections of the inner contour and the outer contour of the inner housing 111 may be circular, or the cross section of the inner contour of the inner housing 111 is circular, and the cross section of the outer contour of the inner housing 111 is square. Correspondingly, a cross section of an inner contour of the outer housing 112 may be a circular, oval, square, or another polygon structure. In addition, shapes of the inner contour and an outer contour of the outer housing 112 may be the same or different. For example, cross sections of the inner contour and the outer contour of the outer housing 112 may be circular, or the cross section of the inner contour of the outer housing 112 is circular, and the cross section of the outer contour of the outer housing 112 is square.

In addition, in specific implementation, the inner housing 111, the outer housing 112, the bottom housing 114, and the upper cover 115 may be mutually independent structural members, or may be partially integrated structural members. For example, in an embodiment provided in this application, the inner housing 111 and the bottom housing 114 are an integrated structural member (or it may be understood that an airtight connection between the inner housing 111 and the bottom housing 114 is implemented by disposing an integrated structure); and the outer housing 112 and the upper cover 115 are an integrated structural member (or it may be understood that an airtight connection between the outer housing 112 and the upper cover 115 is implemented by disposing an integrated structure). The inner housing 111 and the bottom housing 114 may be fabricated into an integrated structure by using a process such as die-cast formation or CNC processing. Correspondingly, the outer housing 112 and the upper cover 115 may also be fabricated into an integrated structure by using a process such as die-cast formation or CNC processing. In addition, in specific implementation, to implement a detachable connection of the housing 11, the outer housing 112 is connected to the bottom housing 114 in a manner of a threaded connection. Specifically, a through hole (not shown in the figure) is disposed on a bottom edge of the outer housing 112, and a threaded hole (not shown in the figure) is disposed on the bottom housing 114. When the housing 11 is assembled, the through hole of the outer housing 112 may be aligned with the threaded hole of the bottom housing 114, and then a bolt is screwed with the threaded hole of the bottom housing 114 after the bolt passes through the through hole of the outer housing 112, to implement a fixed connection between the outer housing 112 and the bottom housing 114. In addition, to ensure airtightness of the accommodating space 113, a sealing ring 1112 may be disposed or a sealant may be applied between an upper end of the inner housing 111 and the upper cover 115. In addition, the outer edge of the bottom housing 114 and the bottom edge of the outer housing 112 may be airtightly connected in a manner of disposing a sealing ring or applying a sealant. When the functional circuit 12 needs to be added, replaced, or detached in the accommodating space 113, the sealant between the bottom housing 114 and the outer housing 112 is detached, and then the bolt is detached to implement detachment of the housing 11. In addition, after an operation such as mounting, replacing, or detaching the functional circuit 12 is completed, a part at which the bottom housing 114 joins the outer housing 112 is re-applied with the sealant for bonding. Therefore, there is high disassembly/assembly flexibility and convenience, and airtightness of the accommodating space 113 can be effectively ensured.

In addition, in some implementations, an outer thread structure (for example, the sealing ring 1112 may be considered as the outer thread structure) may be disposed at the upper end of the inner housing 111, and an inner thread structure is disposed in a through hole 1151 of the upper cover 115. When the housing 11 is assembled, an outer thread of the inner housing 111 may be screwed into the through hole 1151, thereby implementing a threaded connection between the inner housing 111 and the upper cover 115.

It may be understood that, in another implementation, a connection form between composition structures of the housing 11 may alternatively be in another manner. This is not specifically limited in this application.

In addition, as shown in FIG. 3, in specific implementation, the extension assembly 10 may be electrically connected to the main device assembly by using a cable, to meet a power supply requirement of the extension assembly 10 or a signal transmission requirement between the extension assembly 10 and the main device assembly. In an embodiment provided in this application, a cable hole 1141 communicating with the accommodating space 113 is disposed on the bottom housing 114. In specific implementation, to improve airtightness between the cable and the cable hole 1141, the cable hole 1141 may be filled with a structure such as a sealant. Alternatively, a sealing ring (such as a rubber ring) with large elasticity may be disposed at the cable hole 1141. After the cable passes through the cable hole 1141, the sealing ring may be airtightly attached to the cable and a hole wall of the cable hole 1141, thereby ensuring airtightness between the cable hole 1141 and the cable. In addition, in some implementations, the cable may also be provided with a corresponding airtight structure to be airtightly connected to the cable hole 1141. For example, an outer thread structure may be disposed on an outer circumference of the cable, an inner thread structure may be disposed on an inner wall of the cable hole 1141, and the cable and the cable hole 1141 may be screwed tightly to implement a specific airtight connection. In specific implementation, a gap between the cable and the cable hole 1141 may be filled with a sealant, to improve waterproof performance. In addition, in specific configuration, a structure such as an interface or a connector may be further mounted on the cable hole 1141, and the functional circuit 12 may be electrically connected to the main device assembly through the interface or by using the connector.

It may be understood that, in another implementation, there may be two or more cable holes 1141. In addition, a position of the cable hole 1141 is not limited to the bottom housing 114. For example, the cable hole 1141 may alternatively be disposed on the outer housing 112.

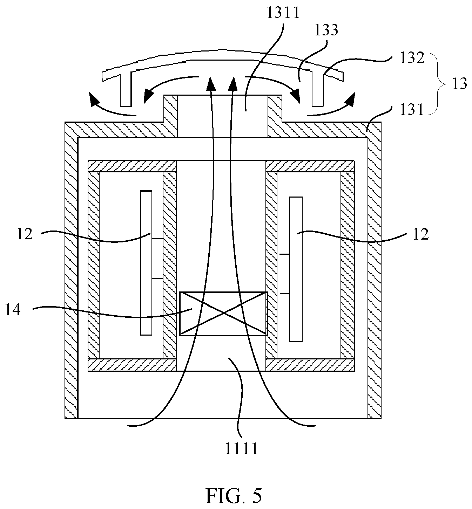

As shown in FIG. 4, in actual application, the extension assembly 10 may be applied to a harsh environment such as an outdoor environment. To improve a use effect of the extension assembly 10, the extension assembly 10 may further include a shielding cover assembly 13. The shielding cover assembly 13 may cover the outside of the outer housing 112 to prevent the outer housing 112 from being exposed to sunlight, resulting in an undesirable case such as a high temperature. In an embodiment provided in this application, the shielding cover assembly 13 includes a shielding cover 131 and a shutter 132. To clearly show a main structure of the shielding cover assembly 13, refer to FIG. 5. The shielding cover 131 may cover a top and an outer circumference of the housing 11. A ventilation hole 1311 is disposed on a top of the shielding cover 131. In specific implementation, the shielding cover 131 may cover the top of the housing 11. In addition, an air flow flowing through the ventilation channel 1111 may also be discharged by using the ventilation hole 1311 of the shielding cover 131. Therefore, the shielding cover 131 does not hinder the ventilation channel 1111 of the inner housing 111, and therefore does not affect heat dissipation performance of the extension assembly 10. In addition, to prevent an impurity such as a leaf from falling into the ventilation channel 1111 to cause blockage, the shutter 132 may be disposed on the top of the shielding cover 131, and a shape contour of the shutter 132 is greater than a shape contour of the ventilation hole 1311, to shield the ventilation hole 1311. In addition, to prevent the shutter 132 from hindering the ventilation channel 1111, a specific ventilation gap 133 is maintained between the shutter 132 and the shielding cover 131, and an air flow entering from a bottom of the ventilation channel 1111 can be discharged upward through the ventilation gap 133. Specifically, after entering the ventilation channel 1111 from the bottom of the ventilation channel 1111, a cooling air flow flows to the top, and then flows through the ventilation hole 1311 of the shielding cover 131 and the ventilation gap 133 between the shielding cover 131 and the shutter 132, and then discharges. In specific implementation, the ventilation gap 133 between the shielding cover 131 and the shutter 132 may be disposed as a complex shape structure, to prevent rain from entering the ventilation channel 1111 through the ventilation gap 133. For example, a plurality of corners may be disposed in the ventilation gap 133, or the ventilation gap 133 may be disposed as a curved structure. It may be understood that the shielding cover 131 and the shutter 132 may be mutually independent structures, or may be an integrated structure. For example, the shielding cover 131 and the shutter 132 may be separately fabricated by using a process such as injection molding, and then fixedly connected in a manner such as bonding or screw connection. Alternatively, the shielding cover 131 and the shutter 132 may be molded into an integrated structure by using a process such as injection molding. In specific implementation, the shielding cover 131 and the shutter 132 may be made of a non-electromagnetic shielding material such as polycarbonate or ABS plastic (including a copolymer of acrylonitrile, butadiene, and styrene), so that no electromagnetic shielding is generated for the functional circuit, and a good protective and shielding effect can be performed on the housing 11.

In addition, in some implementations, only the shielding cover 131 may be disposed but the shutter 132 is omitted. Alternatively, in some other implementations, only the shutter 132 may be disposed but the shielding cover 131 is omitted. Alternatively, in some indoor environments, the shielding cover assembly 13 may be omitted.

In actual application, to improve heat dissipation of the extension assembly 10 by using a principle that a hot air flow rises, after the extension assembly 10 is fastened at a mounting position, the ventilation channel 1111 may maintain a vertical or inclined posture, so that a hot air flow in the ventilation channel 1111 can be smoothly discharged upward.

In addition, as shown in FIG. 5, to improve heat dissipation performance and mounting posture flexibility of the extension assembly 10, in some other implementations, a heat dissipation fan 14 may be further disposed in the extension assembly 10. For example, the heat dissipation fan 14 may be fixedly mounted in the ventilation channel 1111 or at another position, to increase a flow velocity of the air flow flowing through the ventilation channel 1111, thereby improving a heat dissipation capability of the extension assembly 10. In specific implementation, the heat dissipation fan 14 may select a type of strong performance such as waterproof, dustproof, and shockproof, to improve reliability and stability of the heat dissipation fan 14.

In specific implementation, the extension assembly 10 may be adapted to a plurality of types of main device assemblies, to extend or improve functionality of a corresponding main device assembly. In specific implementation, the main device assembly may be an outdoor base station (for example, a base station configured to receive and send a wireless signal), a camera, and the like. In addition, when the extension assembly 10 performs a matching mounting with the main device assembly, disassembly/assembly of the main device assembly does not need to be performed, so that airtightness and reliability of the main device assembly are not affected. In addition, when there are different function requirements of the main device assembly, only corresponding functional circuits need to be mounted in the extension assembly 10, thereby having high flexibility. This can effectively prevent occurrence of an undesirable case of functional insufficiency or functional redundancy.

In addition, the extension assembly 10 provided in this embodiment of this application does not reduce heat dissipation performance of the main device assembly. In some cases, the extension assembly 10 may further improve heat dissipation performance of the main device assembly. For example, when the extension assembly 10 is fixedly mounted on the outer housing of the main device assembly, a first mounting gap communicating with the ventilation channel 1111 may be disposed between the main device outer housing and the housing 11 of the extension assembly 10. When a cooling air flow exists in the ventilation channel 1111, a flow velocity of an air flow in the first mounting gap can be increased, so that heat dissipation performance of the main device assembly can be improved. Alternatively, when the extension assembly 10 is fixedly connected to the main device assembly by using a bracket, a second mounting gap communicating with the ventilation channel 1111 may be disposed between the main device outer housing and the bracket. When a cooling air flow exists in the ventilation channel 1111, a flow velocity of the air flow in the second mounting gap can be increased, so that heat dissipation performance of the main device assembly can be improved. The following uses an example in which the main device assembly is a camera assembly for specific description.

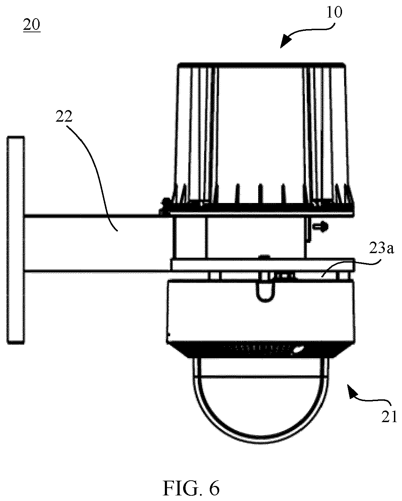

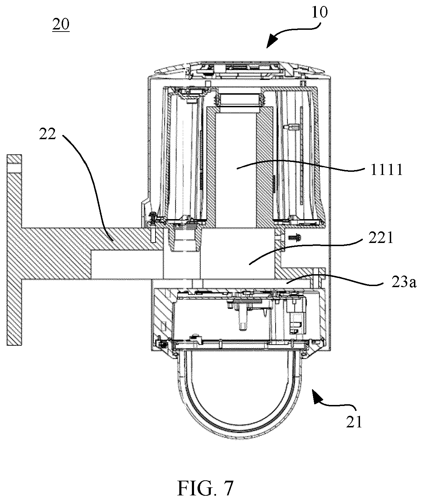

For example, as shown in FIG. 6, in a camera 20 provided in this application, a camera assembly 21 and a bracket 22 are included, and the camera assembly 21 may be fastened at a mounting position (such as a wall or a road monitoring rod) by using the bracket 22. Specifically, the camera assembly 21 may be mounted on a lower side of the bracket 22 in a suspended mounting manner, and there is a specific second mounting gap 23a between the camera assembly 21 and the bracket 22 (that is, there is a second mounting gap 23a between the main device outer housing and the bracket 22). The extension assembly 10 may be fastened on an upper side of the bracket 22. As shown in FIG. 7, the bracket 22 has a connection air duct 221 running through both upper and lower ends. An upper end of the connection air duct 221 may be connected to a lower end of the ventilation channel 1111, and a lower end of the connection air duct 221 communicates with the second mounting gap 23a. In general, the connection air duct 221 located on the bracket 22 may communicate the second mounting gap 23a with the ventilation channel 1111 of the extension assembly 10. The cooling air flow first enters the connection air duct 221 from the second mounting gap 23a. After flowing through the connection air duct 221, the cooling air flow enters the ventilation channel 1111, and then is discharged from an upper end of the ventilation channel 1111. With this structure arrangement, a flow velocity of an air flow flowing through the camera assembly 21 can be increased, so that a heat dissipation effect of the camera assembly can be effectively improved. Specifically, the camera assembly 21 may facilitate a chimney effect of the ventilation channel 1111 to increase a flow velocity of the air flow flowing through an upper side of the camera assembly 21, so that heat generated by the camera assembly 21 can be quickly taken away. In addition, when a heat dissipation fan is mounted in the ventilation channel 1111, a flow velocity of the air flow flowing through the camera assembly 21 is also effectively increased, and heat generated by the camera assembly 21 can also be quickly taken away. That is, the extension assembly 10 does not reduce heat dissipation performance of the camera assembly 21, but can significantly improve heat dissipation performance of the camera assembly 21.

In specific implementation, a mounting manner and a relative position between the camera assembly 21 and the extension assembly 10 may also be flexibly set.

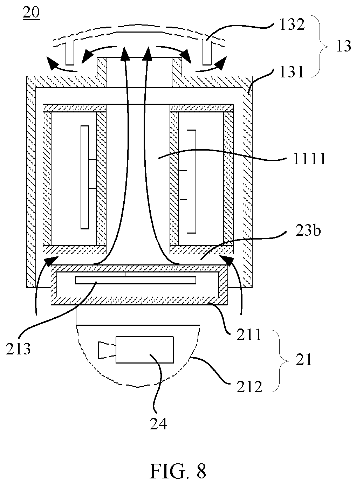

For example, FIG. 8 shows a schematic diagram of a simplified structure of the camera 20. The extension assembly 10 may be directly mounted on an upper side of the camera assembly 21, and a specific first mounting gap 23b may also be disposed between the extension assembly 10 and the camera assembly 21 (that is, the first mounting gap 23b is disposed between the main device outer housing and the housing 11 of the extension assembly 10). Specifically, the cooling air flow may directly enter the ventilation channel 1111 from the first mounting gap 23b, and then be discharged from the top of the ventilation channel 1111.

Still referring to FIG. 8, when the shielding cover assembly 13 is mounted in the extension assembly 10, a lower end of the shielding cover 131 may extend to a periphery of the camera 20 (for example, the base 211), and a specific gap may be maintained between the shielding cover 131 and the camera 20. The external air flow may enter the first mounting gap 23b from the gap and flow upward through the ventilation channel 1111. After the air flow is discharged from the top of the ventilation channel 1111, the air flow flows to the shutter 132, and is discharged to the outside through a gap between the shutter 132 and the shielding cover 131.

In specific implementation, to effectively improve heat dissipation of the camera assembly 21, a heating element located in the camera assembly 21 may be mounted at a position close to the first mounting gap 23b. For example, in the embodiment provided in this application, the outer housing of the camera assembly 21 includes a base 211 and a dome cover 212. The base 211 and the dome cover 212 may enclose to form an airtight space used to mount a lens 24, to provide good protection for the lens 24. In addition, a heating element in the main body circuit 213 may be in heat contact with the base 211 by using a thermal pad or a thermal adhesive, to improve heat dissipation of the heating element.

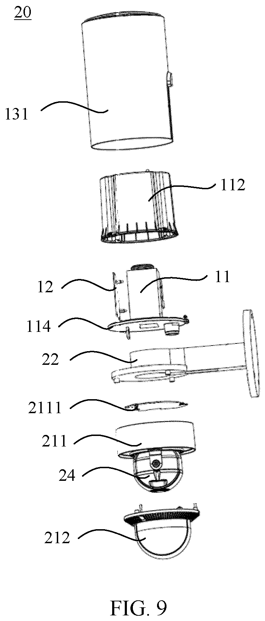

As shown in FIG. 9, in specific implementation, a metal baseplate 2111 may be disposed in the base 211, the base 211 (or the camera assembly 21) may be fixedly connected to the bracket 22 by using the metal baseplate 2111, and a specific mounting gap may be maintained between the metal baseplate 2111 and the bracket 22. In actual application, to improve heat dissipation of the main body circuit 213, the main body circuit 213 may be attached to a side of the metal baseplate 2111. In addition, in specific configuration, a structure such as an interface or a connector may be further disposed on the base 211, and the main body circuit 213 may be electrically connected to the functional circuit 12 in the extension assembly 10 by using the interface or the connector.

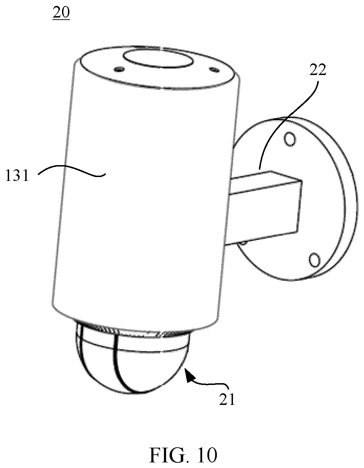

It may be understood that, in specific implementation, shapes and structures of the bracket 22 may be various. In addition, both the camera assembly 21 and the extension assembly 10 may be fastened at mounting positions by using the bracket 22. Alternatively, the camera assembly 21 may be fastened at a mounting position by using the bracket 22, and the extension assembly 10 may be directly fastened to the camera assembly 21. Alternatively, the extension assembly 10 may be fastened at a mounting position by using the bracket 22, and the camera assembly 21 may be directly fastened to the extension assembly 10. As shown in FIG. 10, in specific implementation, to avoid interference between the shielding cover 131 and the bracket 22, the shielding cover 131 may be provided with a notch (not shown in the figure) for a cross beam of the bracket 22 to pass through, so that the shielding cover 131 can smoothly cover a periphery of the camera assembly 21.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic device, comprising a main device assembly (21) and an extension assembly (10), wherein
the main device assembly (21) comprises a main body circuit (213);
the extension assembly (10) comprises one or more functional circuits (12) and a housing (11); at least one of the one or more functional circuits (12) is electrically connected to the main body circuit (213); and the housing (11) comprises an inner housing (111) and an outer housing (112);
a ventilation channel (1111) is formed on an inner circumference of the inner housing (111);
the outer housing (112) is disposed on an outer circumference of the inner housing (111), and the inner housing (111) and the outer housing (112) enclose to form an accommodating space (113); and
the functional circuit (12) is disposed in the accommodating space (113) and is in heat contact with the inner housing (111), so that heat dissipation is performed on the functional circuit (12) through an air flow in the ventilation channel (1111);
wherein the main device assembly (21) is detachably connected to the extension assembly (10);
wherein the main device assembly (21) comprises a main device outer housing, and the main body circuit (213) is disposed in the main device outer housing and the main device outer housing is detachably connected to the housing; and
**characterized in that** a first mounting gap (23b) exists between the main device outer housing and the housing (11), and the first mounting gap (23b) communicates with an end of the ventilation channel (1111).

2. The electronic device according to claim 1, wherein the main device outer housing comprises a base, and the base is located on a side of the first mounting gap; and
the main body circuit comprises a heating element, and the heating element is in heat contact with the base, so that heat dissipation is performed on the heating element through an air flow in the first mounting gap.

3. The electronic device according to claim 1 or claim 2, wherein the functional circuit (12) comprises a heating element, and the heating element is in heat contact with the inner housing (111).

4. The electronic device according to any one of claims 1 to 3, wherein the housing of the extension assembly (10) further comprises a bottom housing (114) and an upper cover (115);
the outer housing (112) is sleeved onto the outer circumference of the inner housing (111);
a first end of the inner housing (111) and a first end of the outer housing (112) are airtightly connected by using the bottom housing (114);
a second end of the inner housing (111) and a second end of the outer housing (112) are airtightly connected by using the upper cover (115); and
the bottom housing (114) has a first through hole for communicating one end of the ventilation channel (1111) with the outside, and the upper cover (115) has a second through hole (1151) for communicating the other end of the ventilation channel (1111) with the outside.

5. The electronic device according to claim 4, wherein an inner thread is disposed on an inner edge of the second through hole, an outer thread is disposed on the second end of the inner housing (111), and the second end of the inner housing (111) and the upper cover (115) are screwed through the inner thread and the outer thread.

6. The electronic device according to any one of claims 1 to 5, further comprising a shielding cover (131), wherein
the shielding cover (131) covers a top and an outer circumference of the housing (11), and a top of the shielding cover (131) has a ventilation hole (1311) communicating with the ventilation channel (1111).

7. The electronic device according to claim 6, wherein when the functional circuit (12) comprises a wireless communication circuit, the shielding cover (131) is made of a non-electromagnetic shielding material.

8. The electronic device according to claim 6 or 7, wherein the shielding cover (131) further covers an outer circumference of the outer housing (112), and a gap exists between the shielding cover (131) and the outer housing (112).

9. The electronic device according to any one of claims 6 to 8, further comprising a shutter (132), wherein
the shutter (132) covers the ventilation hole (1311) on the top of the shielding cover (131), and a ventilation gap (1330) is disposed between the shutter (132) and the shielding cover (131).

## Patentansprüche

1. Elektronische Vorrichtung, umfassend eine Hauptvorrichtungsbaugruppe (21) und eine Erweiterungsbaugruppe (10), wobei
die Hauptvorrichtungsbaugruppe (21) eine Hauptkörperschaltung (213) umfasst;
die Erweiterungsbaugruppe (10) eine oder mehrere Funktionsschaltungen (12) und ein Gehäuse (11) umfasst; mindestens eine der Funktionsschaltungen (12) elektrisch mit der Hauptkörperschaltung (213) verbunden ist; und das Gehäuse (11) ein Innengehäuse (111) und ein Außengehäuse (112) umfasst;
ein Lüftungskanal (1111) an einem Innenumfang des Innengehäuses (111) ausgebildet ist;
das Außengehäuse (112) an einem Außenumfang des Innengehäuses (111) angeordnet ist, und sich das Innengehäuse (111) und das Außengehäuse (112) umschließen, um einen Aufnahmeraum (113) auszubilden; und
die Funktionsschaltung (12) in dem Aufnahmeraum (113) angeordnet ist und in Wärmekontakt mit dem Innengehäuse (111) steht, so dass eine Wärmeableitung über einen Luftstrom in dem Lüftungskanal (1111) an der Funktionsschaltung (12) durchgeführt wird;
wobei die Hauptvorrichtungsbaugruppe (21) lösbar mit der Erweiterungsbaugruppe (10) verbunden ist;
wobei die Hauptvorrichtungsbaugruppe (21) ein Außengehäuse der Hauptvorrichtung umfasst, die Hauptkörperschaltung (213) in dem Außengehäuse der Hauptvorrichtung angeordnet ist und das Außengehäuse der Hauptvorrichtung lösbar mit dem Gehäuse verbunden ist; und
**dadurch gekennzeichnet, dass**
ein erster Montagespalt (23b) zwischen dem Außengehäuse der Hauptvorrichtung und dem Gehäuse (11) besteht, und der erste Montagespalt (23b) mit einem Ende des Lüftungskanals (1111) in Verbindung steht.

2. Elektronische Vorrichtung nach Anspruch 1, wobei das Außengehäuse der Hauptvorrichtung eine Basis umfasst, und sich die Basis auf einer Seite des ersten Montagespalts befindet; und die Hauptkörperschaltung ein Heizelement umfasst, und das Heizelement in Wärmekontakt mit der Basis steht, so dass die Wärmeableitung über einen Luftstrom in dem ersten Montagespalt an das Heizelement durchgeführt wird.

3. Elektronische Vorrichtung nach Anspruch 1 oder 2, wobei die Funktionsschaltung (12) ein Heizelement umfasst, und das Heizelement in Wärmekontakt mit dem Innengehäuse (111) steht.

4. Elektronische Vorrichtung nach einem der Ansprüche 1 bis 3, wobei das Gehäuse der Erweiterungsbaugruppe (10) ferner ein unteres Gehäuse (114) und eine obere Abdeckung (115) umfasst; das Außengehäuse (112) auf den Außenumfang des Innengehäuses (111) aufgeschoben ist;
ein erstes Ende des Innengehäuses (111) und ein erstes Ende des Außengehäuses (112) unter Verwendung des unteren Gehäuses (114) luftdicht verbunden sind;
ein zweites Ende des Innengehäuses (111) und ein zweites Ende des Außengehäuses (112) unter Verwendung der oberen Abdeckung (115) luftdicht verbunden sind; und
das untere Gehäuse (114) ein erstes Durchgangsloch zum Herstellen einer Verbindung zwischen einem Ende des Lüftungskanals (1111) und der Außenseite aufweist, und die obere Abdeckung (115) ein zweites Durchgangsloch (1151) aufweist, um das andere Ende des Belüftungskanals (1111) mit der Außenseite zu verbinden.

5. Elektronische Vorrichtung nach Anspruch 4, wobei ein Innengewinde auf einer Innenkante des zweiten Durchgangslochs angeordnet ist, ein Außengewinde an dem zweiten Ende des Innengehäuses (111) angeordnet ist, und das zweite Ende des Innengehäuses (111) und die obere Abdeckung (115) über das Innengewinde und das Außengewinde verschraubt sind.

6. Elektronische Vorrichtung nach einem der Ansprüche 1 bis 5, ferner umfassend eine Abschirmabdeckung (131), wobei
die Abschirmabdeckung (131) eine Oberseite und einen Außenumfang des Gehäuses (11) abdeckt, und eine Oberseite der Abschirmabdeckung (131) ein Lüftungsloch (1311) aufweist, das mit dem Lüftungskanal (1111) in Verbindung steht.

7. Elektronische Vorrichtung nach Anspruch 6, wobei, wenn die Funktionsschaltung (12) eine drahtlose Kommunikationsschaltung umfasst, die Abschirmabdeckung (131) aus einem nichtelektromagnetischen Abschirmmaterial hergestellt ist.

8. Elektronische Vorrichtung nach Anspruch 6 oder 7, wobei die Abschirmabdeckung (131) ferner einen Außenumfang des Außengehäuses (112) abdeckt, und ein Spalt zwischen der Abschirmabdeckung (131) und dem Außengehäuse (112) besteht.

9. Elektronische Vorrichtung nach einem der Ansprüche 6 bis 8, ferner umfassend einen Verschluss (132), wobei
der Verschluss (132) das Lüftungsloch (1311) auf der Oberseite der Abschirmabdeckung (131) abdeckt, und ein Lüftungsspalt (1330) zwischen dem Verschluss (132) und der Abschirmabdeckung (131) angeordnet ist.

## Revendications

1. Dispositif électronique, comprenant un ensemble de dispositif principal (21) et un ensemble d'extension (10), dans lequel
l'ensemble de dispositif principal (21) comprend un circuit de corps principal (213) ;
l'ensemble d'extension (10) comprend un ou plusieurs circuits fonctionnels (12) et un boîtier (11) ; au moins un des un ou plusieurs circuits fonctionnels (12) est électriquement relié au circuit de corps principal (213) ; et le boîtier (11) comprend un boîtier interne (111) et un boîtier externe (112) ;
un canal de ventilation (1111) est formé sur une circonférence interne du boîtier interne (111) ;
le boîtier externe (112) est disposé sur une circonférence externe du boîtier interne (111), et le boîtier interne (111) et le boîtier externe (112) s'entourent pour former un espace d'accueil (113) ; et
le circuit fonctionnel (12) est disposé dans l'espace d'accueil (113) et est en contact thermique avec le boîtier interne (111), de sorte que la dissipation de chaleur est réalisée sur le circuit fonctionnel (12) à travers un écoulement d'air dans le canal de ventilation (1111) ;
dans lequel l'ensemble de dispositif principal (21) est connecté de manière détachable à l'ensemble d'extension (10) ;
dans lequel l'ensemble de dispositif principal (21) comprend un boîtier externe de dispositif principal, et le circuit de corps principal (213) est disposé dans le boîtier externe de dispositif principal et le boîtier externe de dispositif principal est relié de manière détachable au boîtier ; et
**caractérisé en ce que**
un premier espace de montage (23b) existe entre le boîtier externe de dispositif principal et le boîtier (11), et le premier espace de montage (23b) communique avec une extrémité du canal de ventilation (1111).

2. Dispositif électronique selon la revendication 1, dans lequel le boîtier externe de dispositif principal comprend une base, et la base est située d'un côté du premier espace de montage ; et
le circuit de corps principal comprend un élément chauffant, et l'élément chauffant est en contact thermique avec la base, de sorte que la dissipation de la chaleur est réalisée sur l'élément chauffant à travers un écoulement d'air dans le premier espace de montage.

3. Dispositif électronique selon la revendication 1 ou la revendication 2, dans lequel le circuit fonctionnel (12) comprend un élément chauffant, et l'élément chauffant est en contact thermique avec le boîtier interne (111).

4. Dispositif électronique selon l'une quelconque des revendications 1 à 3, dans lequel le boîtier de l'ensemble d'extension (10) comprend également un boîtier inférieur (114) et un couvercle supérieur (115) ;
le boîtier externe (112) est emboîté sur la circonférence externe du boîtier interne (111) ;
une première extrémité du boîtier interne (111) et une première extrémité du boîtier externe (112) sont reliées de manière étanche à l'air à l'aide du boîtier inférieur (114) ;
une seconde extrémité du boîtier interne (111) et une seconde extrémité du boîtier externe (112) sont reliées de manière étanche à l'air par le couvercle supérieur (115) ; et
le boîtier inférieur (114) a un premier trou traversant pour communiquer une extrémité du canal de ventilation (1111) avec l'extérieur, et le couvercle supérieur (115) a un second trou traversant (1151) pour communiquer l'autre extrémité du canal de ventilation (1111) avec l'extérieur.

5. Dispositif électronique selon la revendication 4, dans lequel un filetage interne est disposé sur un bord interne du second trou traversant, un filetage externe est disposé sur la seconde extrémité du boîtier interne (111), et la seconde extrémité du boîtier interne (111) et le couvercle supérieur (115) sont vissés à travers le filetage interne et le filetage extérieur.

6. Dispositif électronique selon l'une quelconque des revendications 1 à 5, comprenant également un couvercle de protection (131), dans lequel
le couvercle de protection (131) recouvre le dessus et une circonférence externe du boîtier (11), et le dessus du couvercle de protection (131) a un trou de ventilation (1311) communiquant avec le canal de ventilation (1111).

7. Dispositif électronique selon la revendication 6, dans lequel lorsque le circuit fonctionnel (12) comprend un circuit de communication sans fil, le couvercle de protection (131) est constitué d'un matériau de protection non électromagnétique.

8. Dispositif électronique selon la revendication 6 ou 7, dans lequel le couvercle de protection (131) recouvre également une circonférence externe du boîtier externe (112), et un espace existe entre le couvercle de protection (131) et le boîtier externe (112).

9. Dispositif électronique selon l'une quelconque des revendications 6 à 8, comprenant également un obturateur (132), dans lequel
l'obturateur (132) recouvre le trou de ventilation (1311) sur le dessus du couvercle de protection (131), et un espace de ventilation (1330) est disposé entre l'obturateur (132) et le couvercle de protection (131).
